# EUROPEAN PATENT APPLICATION

(11) **EP 1 744 376 A2**
(43) Date of publication of application: **17.01.2007**
(21) Application number: 06253640.4
(22) Date of filing: 12.07.2006
(51) Int. Cl.: H01L 33/00, H01L 25/075

(54) **Semiconductor device and manufacturing method thereof**

(30) Priority: 13.07.2005 JP 2005204794
(71) Applicant: SHINKO ELECTRIC INDUSTRIES CO., LTD., Nagano-shi, Nagano 381-2287 (JP)
(72) Inventor: Shiraishi, Akinori c/o Shinko Electric Inc Co. Ltd, Nagano-shi, Nagano 381-2287 (JP); Higashi, Mitsutoshi c/o Shinko Electric Inc Co Ltd, Nagano-shi, Nagano 381-2287 (JP); Taguchi, Yuichi c/o Shinko Electric Inc Co. Ltd, Nagano-shi, Nagano 381-2287 (JP)
(74) Representative: Rees, Alexander Ellison

(57) **Abstract**

A manufacturing method of a semiconductor device is disclosed. The manufacturing method includes a first step that mounts plural semiconductor elements (107) on a first substrate (101), a second step that inspects each of the semiconductor elements (107) mounted on the first substrate (101), a third step that divides the first substrate (101) by dicing so that a divided first substrate (101) includes at least one semiconductor element (107), and a fourth step that mounts the divided first substrate (101) in which at least one semiconductor element (107) is mounted on a second substrate (201).

## Description

### BACKGROUND OF THE INVENTION

### 1. Field of the Invention

The present invention generally relates to a semiconductor device and a manufacturing method thereof in which a substrate on which a semiconductor element is mounted is further mounted on another substrate.

### 2. Description of the Related Art

There are various kinds of semiconductor devices on which a semiconductor element is mounted. For example, when the semiconductor element is an optical function element having a light emitting function or a photoelectric conversion function, the semiconductor device can be used as a displaying device, a communicating device, a measuring device, a controlling device, and so on. Such a semiconductor device is formed by mounting an optical function element on a predetermined substrate on which wirings are formed.

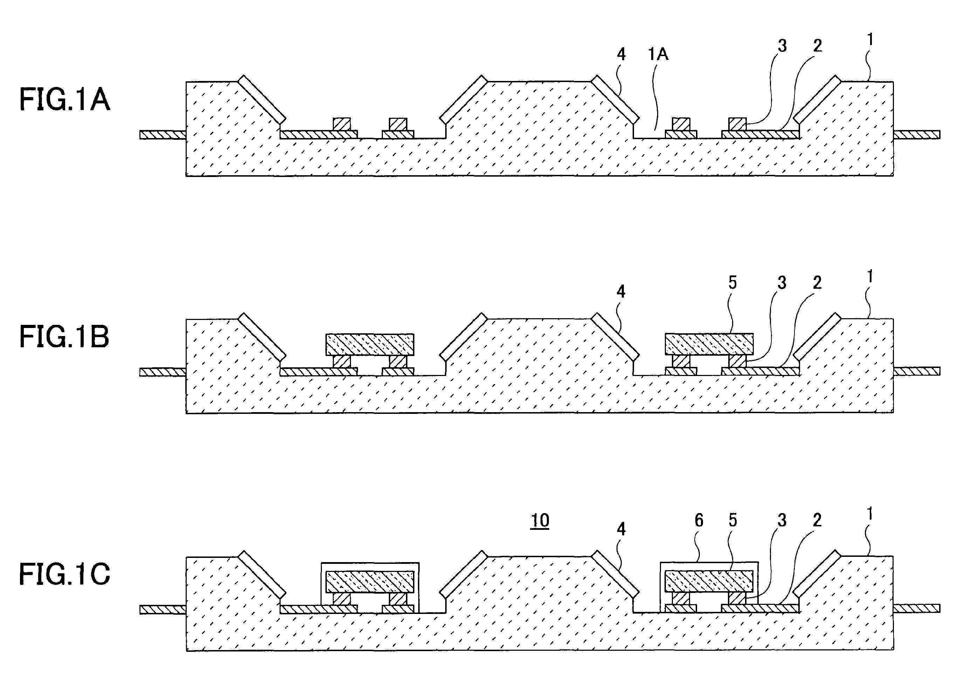

Figs. 1A through 1C are schematic cross-sectional views showing processes for manufacturing a semiconductor device on which an LED (light emitting diode) is mounted.

Referring to Figs. 1A through 1C, manufacturing processes of the semiconductor device are described.

First, in a process shown in Fig. 1A, a substrate 1 is prepared. The substrate 1 is made of, for example, a ceramic material, and a concave section 1A is formed in the substrate 1. A semiconductor element is mounted on the concave section 1A in a later process. In addition, a wiring section 2, which is to be connected to the semiconductor element to be mounted, is formed on the bottom surface of the concave section 1A, and connecting layers (bumps) 3 made of Au are formed on the wiring section 2.

The side wall of the concave section 1A is formed to have, for example, a taper-shaped surface and a reflection surface 4 is formed on the side wall surface.

Next, in a process shown in Fig. 1B, a semiconductor element 5 (for example, an LED) is mounted on the connecting layers 3. In this case, the semiconductor element 5 is connected to the wiring section 2 via the connecting layers 3.

Next, in a process shown in Fig. 1C, a fluorescent substance layer 6 is applied so as to cover the semiconductor element 5. For example, an LED emits a predetermined color light; however, the kinds of colors are limited. Therefore, when a desired color light is obtained, in some cases, a mixed color is obtained by mixing a color light emitted from the LED with a color light emitted from the fluorescent substance. In this case, the color light to be emitted from the fluorescent substance is determined corresponding to the color light of the LED. Further, a coloring material can be mixed into the fluorescent substance.

By the processes described above, a semiconductor device 10 in which the semiconductor element (LED) 5 is mounted on the substrate 1 is formed. In the above description, only one LED is used; however, the number of LEDs is not limited to one, and plural LEDs can be mounted on the substrate 1.

Related art cases are described in the following documents.
[Patent Document 1] Japanese Laid-Open Patent Application No. 2003-163381 (United States Patent No. 6774406)
[Patent Document 2] Japanese Laid-Open Patent Application No. 2003-168828
[Patent Document 3] Japanese Laid-Open Patent Application No. 2004-260169 (United States Patent Application Publication No. US2004/0166234)

In the above documents, a technology in which an LED is coated by resin containing a fluorescent substance is disclosed. However, a semiconductor device in which a substrate on which an LED is mounted is further mounted on another substrate is not disclosed.

In the above described semiconductor device, in some cases, a defective semiconductor device is manufactured caused by, for example, irregular color and poor light emission due to an individual difference of the LED which is mounted on the substrate.

In addition, for example, when the thickness of the fluorescent substance layer 6 applied on the semiconductor element 5 is dispersed, irregular color occurs.

Further, in a case where a light emitting state of each semiconductor element such as an LED is inspected before mounting on a substrate, excessive time and workload are needed; consequently, the inspection cannot be actually executed. In addition, it is difficult to find the poor light emission until the process shown in Fig. 1C is finished or at least the process shown in Fig. 1B is finished. Accordingly, when a defective semiconductor device is found after the semiconductor elements are mounted, the defective semiconductor device on which plural semiconductor elements are mounted must be discarded.

### SUMMARY OF THE INVENTION

It is a general object of the present invention to provide a semiconductor device and a manufacturing method thereof that are novel and useful so as to substantially obviate one or more of the problems caused by the limitations and disadvantages of the related art.

Features and advantages of the present invention are set forth in the description which follows, and in part will become apparent from the description and the accompanying drawings, or may be learned by practice of the invention according to the teachings provided in the description. Features and advantages of the present invention may be realized and attained by a semiconductor device and a manufacturing method thereof particularly pointed out in the specification in such full, clear, concise, and exact terms as to enable a person having ordinary skill in the art to practice the invention.

According to one aspect of the present invention, there is provided a manufacturing method of a semiconductor device. The manufacturing method includes a first step that mounts plural semiconductor elements on a first substrate, a second step that inspects each of the semiconductor elements mounted on the first substrate, a third step that divides the first substrate by dicing so that a divided first substrate includes at least one semiconductor element, and a fourth step that mounts the divided first substrate in which at least one semiconductor element is mounted on a second substrate.

Since each of the plural semiconductor elements is inspected in the second step and inspected semiconductor elements are mounted on the second substrate in the fourth step, an individual difference among the plural semiconductor elements which are mounted on the second substrate is prevented and the yield in manufacturing the semiconductor device can be increased.

When the semiconductor element is an optical function element, it is conventionally difficult to inspect the optical function element while the semiconductor device is being manufactured. However, the optical function element can be inspected when the optical function element is mounted on the first substrate; therefore, the yield in manufacturing the semiconductor device can be increased.

In addition, when the first step includes a step of forming an optical function layer which operates for a transmission light on the semiconductor element, the dispersion of the coating of the optical function layers on the semiconductor element can be inspected. Consequently, the dispersion of the optical function layers in the semiconductor devices can be decreased.

In addition, when the semiconductor element is an LED and the optical function layer is a fluorescent substance layer, a semiconductor device having a light emitting function can be manufactured at high productivity by combining the LED and the fluorescent substance layer.

In addition, since the second step includes an inspection while the LED is emitting light, a defective LED can be rejected before mounting the LED on the second substrate.

In addition, when the optical function layer is formed by an inkjet method, a defective optical function layer caused by non-uniform coating can be avoided.

In addition, when wiring sections formed on the first substrate are connected to the semiconductor element via connecting sections by ultrasonic bonding, since solder is not used, contamination of the semiconductor element caused by flux of the solder can be prevented.

In addition, when wiring sections formed in the first substrate are connected to a wiring section formed on the second substrate by solder, the certainty of the connection can be obtained.

According to another aspect of the present invention, there is provided a semiconductor device. The semiconductor device includes a first substrate on which a semiconductor element is mounted and a second substrate on which the first substrate is mounted. The semiconductor element is an optical function element and an optical function layer which operates for a transmission light is formed on the optical function element.

Since the semiconductor element mounted on the first substrate is inspected before being mounted on the second substrate, the dispersion of the characteristics of the semiconductor elements can be decreased. In addition, when the semiconductor element is mounted on the second substrate in a state where the semiconductor element has been mounted on the first substrate, the position and the angle of the semiconductor element on the second substrate can be determined at high accuracy.

In addition, when the semiconductor element is an LED, the dispersion of light emission of the LED can be decreased and the position and the angle of the LED on the second substrate can be determined at high accuracy.

In addition, when the optical function layer is a fluorescent substance layer, a desired color light can be obtained.

In addition, when a concave section is formed in the second substrate so as to contain the first substrate on which the semiconductor element is mounted and a reflection surface is formed on the concave section, the light emitting efficiency can be increased.

In addition, since wiring sections are formed to penetrate the first substrate and connect the semiconductor element to a wiring section formed on the second substrate, a thin semiconductor device can be obtained.

In addition, a concave section is formed in the second substrate so as to contain the first substrate on which the semiconductor element is mounted, a reflection surface is formed on the concave section and wiring sections are formed on the first substrate so as to connect to the semiconductor element via connecting layers, and the connecting sections are connected to a wiring section formed on the second substrate by wire bonding. Therefore, the certainty of the connection can be obtained.

In addition, a concave section is formed in the first substrate so as to contain the semiconductor element, the concave section is filled with an optical function layer, wiring sections are formed to penetrate the first substrate so as to connect the semiconductor element to a second substrate via connecting sections, and the wiring sections are connected to a wiring section formed on the second substrate by solder; therefore the certainty of the connection can be obtained.

In addition, a concave section is formed in the first substrate so as to contain the semiconductor element. The concave section is formed to have a taper shape, a reflection surface is formed on the taper-shaped surface of the concave section, an optical function layer is formed to cover the semiconductor element, wiring sections are formed to penetrate the first substrate so as to connect the semiconductor element to a second substrate via connecting sections, and the wiring sections are connected to a wiring section formed on the second substrate by solder; therefore the certainty of the connection can be obtained.

In addition, since the first substrate is a silicon substrate, the transfer of heat can be excellent.

According to embodiments of the present invention, a semiconductor device and a manufacturing method of the semiconductor device can be provided in which an individual difference of characteristics among semiconductor elements can be decreased and the yield in manufacturing the semiconductor device can be increased.

Features and advantages of the present invention will become apparent from the following detailed description when read in conjunction with the accompanying drawings.

### BRIEF DESCRIPTION OF THE DRAWINGS

Figs. 1A through 1C are schematic cross-sectional views showing processes for manufacturing a semiconductor device on which an LED is mounted;
Figs. 2A through 2F are schematic cross-sectional views showing processes in a manufacturing method of a semiconductor device according to a first embodiment of the present invention;
Fig. 3 is a schematic cross-sectional view showing a semiconductor device according to a second embodiment of the present invention;
Fig. 4 is a schematic cross-sectional view showing a modified example of the second embodiment shown in Fig. 3;
Fig. 5 is a schematic cross-sectional view showing a semiconductor device according to a third embodiment of the present invention; and
Fig. 6 is a schematic cross-sectional view showing a semiconductor device according to a fourth embodiment of the present invention.

### DESCRIPTION OF THE PREFERRED EMBODIMENTS

In the following, embodiments of the present invention are described with reference to the accompanying drawings.

### [First Embodiment]

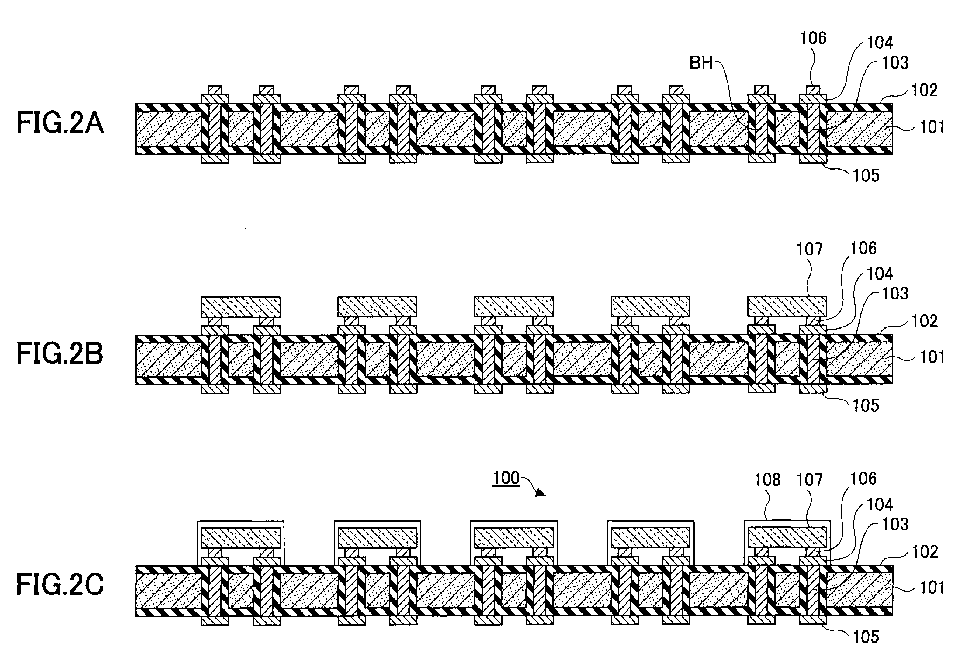

Figs. 2A through 2F are schematic cross-sectional views showing processes in a manufacturing method of a semiconductor device according to a first embodiment of the present invention.

Referring to Figs. 2A through 2F, the manufacturing method of the semiconductor device according to the first embodiment of the present invention is described.

In the following description, the manufacturing method for one semiconductor device is mainly explained; however, the number of the semiconductor devices is not limited to one, and plural semiconductor devices are actually formed at the same time.

First, in a process shown in Fig. 2A, via holes BH are formed in a substrate 101 made of, for example, a silicon wafer, and an insulation layer 102 is formed on the surface of the substrate 101 and on the inner wall surface of the via holes BH. The insulation layer 102 can be formed by various methods. For example, a film of an organic material such as a resin material is formed by an electrodeposition method, or a film of an inorganic material such as SiO₂ or SiN is formed by a CVD (chemical vapor deposition) method or a sputtering method.

Next, via plugs 103 are formed so as to fill the via holes BH and pattern wirings 104 and 105 are formed so as to connect to the via plugs 103 by, for example, a Cu plating method. For example, the via plugs 103 and the pattern wirings 104 and 105 are formed by Cu electrolytic plating; however, it is preferable that a Cu layer which is a seed layer be formed by electroless plating, a CVD method, or a sputtering method before applying the Cu electrolytic plating.

The via plugs 103 are formed to penetrate the substrate 101. The pattern wirings 104 are formed at the side where a semiconductor element is mounted of the substrate 101 at a later process (hereinafter this side is referred to as the first side). The pattern wirings 105 are formed at the side opposite to the first side of the substrate 101 (hereinafter this side is referred to as the second side).

Next, connecting layers (bumps) 106 are formed on the pattern wirings 104 so that the pattern wirings 104 can be excellently electrically connected to the semiconductor element. The connecting layers 106 are formed of, for example, Au; however, the connecting layers 106 can be formed of another metal, or of a layer in which plural metals are stacked. For example, the connecting layers 106 can be formed by Au plating, or can be a stud bump of Au by wire bonding.

Next, in a process shown in Fig. 2B, a semiconductor element 107 which is an optical function element such as an LED is mounted on the substrate 101. The semiconductor element 107 is connected to the connecting layers 106 by ultrasonic bonding. Or the semiconductor element 107 can be connected to the connecting layers 106 by wire bonding. In this case, in order to make the bonding ability high, it is preferable that the connecting layers 106 be Au plating layers. The semiconductor element 107 is an optical function element, for example, a photoelectric conversion element such as a photo diode or a light emitting element such as an LED. However, the semiconductor element 107 is not limited to the above elements.

Next, in a process shown in Fig. 2C, an optical function layer 108 which operates for a transmission light is formed on the semiconductor element 107 by, for example, coating so as to cover the semiconductor element 107. With this, a first mounted structure 100 is formed in which structure the substrate 101, the insulation layer 102, the via plugs 103, the pattern wirings 104 and 105, the connecting layers 106, the semiconductor element 107, and the optical function layer 108 are formed.

For example, when the semiconductor element 107 is a photoelectric conversion element such as a photo-detecting element, the optical function layer 108 is a filter which blocks a predetermined wavelength of light input to the semiconductor element 107 or a lens which condenses a predetermined wavelength of light input to the semiconductor element 107.

In addition, when the semiconductor element 107 is a light emitting element such as an LED, the optical function layer 108 is a filter which blocks a predetermined wavelength of light emitted from the semiconductor element 107, a lens which condenses a predetermined wavelength of light emitted from the semiconductor element 107, or a fluorescent substance layer by which a desired color light is obtained.

In the present embodiment, the semiconductor element 107 is an LED and the optical function layer 108 is a fluorescent substance layer. By combining the LED 107 with the fluorescent substance layer 108, an emitted color light can be changed to a desired color light.

It is preferable that the optical function layer 108 be formed by coating a fluorescent substance by, for example, an inkjet method. When the inkjet method is used, the uniformity of the thickness of the fluorescent substance layer can be excellently obtained, compared with cases of using a screen printing method, a dispenser, a spray coater, or a roll coater. Therefore, the irregularity of light emission in the semiconductor device can be prevented. In addition, in the inkjet method, a mask is not needed and the coating can be executed at high speed and high efficiency, further, the coating can be applied at a necessary position with a necessary thickness by patterning. Therefore, the coating can be applied to a position such as a cavity where a concave part is formed. In addition, the uniformity of the concentration of the fluorescent substance can be excellent when the fluorescent substance layer is formed by the inkjet method.

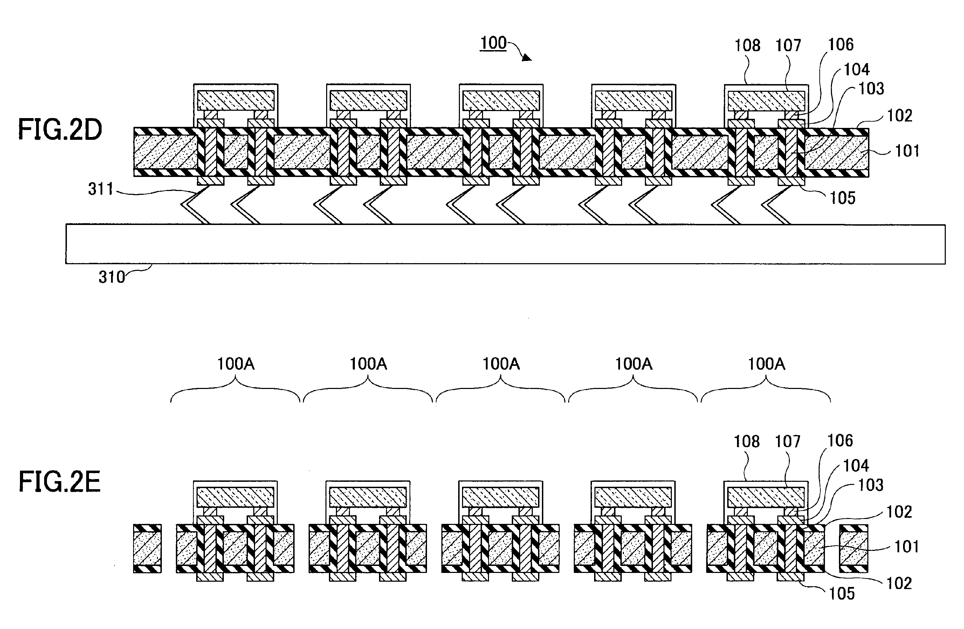

Next, in a process shown in Fig. 2D, the first mounted structure 100 is put on an inspection board 310. Test wirings (contact probes) 311 are formed on the inspection board 310 to connect to the pattern wirings 105.

The first mounted structure 100 is connected to an inspection circuit (not shown) via the test wirings 311 and the semiconductor element 107 mounted on the substrate 101 is inspected. The test wirings 311 are contact probes or connector pins which are electrically connected to the semiconductor element 107 and execute various inspections by driving the semiconductor element 107. The contact probes or the connector pins are shaped to form a spring so as to contact the pattern wirings 105 by a force of elasticity and be electrically connected to the pattern wirings 105.

For example, in the present embodiment, a light emission inspection of an LED (the semiconductor element 107) is executed using power supplied via the test wirings 311. That is, the LED emits light by being driven and characteristics of the light emission such as intensity and color (wavelength) are inspected. Further, individual differences of the above characteristics among plural LEDs are inspected. As described above, actually, plural LEDs are mounted on the substrate 101.

In addition, since the inspection is executed where the optical function layer 108 is formed on the semiconductor element (LED) 107, a level that color irregularity and thickness nonuniformity of the optical function layer 108 give to the dispersion of the light emission can be also inspected. That is, the light emission from the semiconductor element 107 combined with the optical function layer 108 can be inspected.

Next, in a process shown in Fig. 2E, the first mounted structure 100 is divided into plural first mounted structures 100A by, for example, dicing by a dicer. That is, the plural first mounted structures 100A are obtained, in which each structure 100A provides the substrate 101, the insulation layer 102, the via plugs 103, the pattern wirings 104 and 105, the connecting layers 106, the semiconductor element 107, and the optical function layer 108. In this case, for example, the first mounted structure 100A is obtained so that one semiconductor element (LED) 107 is mounted. However, the first mounted structure 100A can be formed so that plural semiconductor elements (LEDs) 107 are mounted, or the first mounted structure 100A can be formed so that plural semiconductor elements (LEDs) 107 are mounted with one or more other elements (not shown).

When a defective semiconductor element 107 and/or a defective optical function layer 108 is detected in the process shown in Fig. 2D, the first mounted structure 100A having the defective element and/or the layer is selectively discarded after the process shown in Fig. 2E.

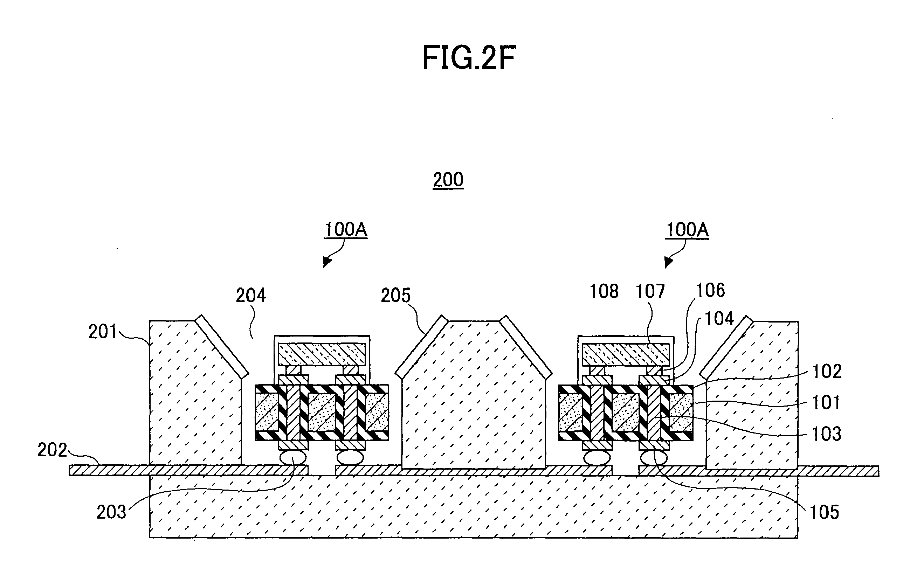

Next, in a process shown in Fig. 2F, a semiconductor device (second mounted structure) 200 is formed by mounting the first mounted structure 100A on a substrate 201. The substrate 201 is made of, for example, a ceramic material and a concave section 204 is formed in the substrate 201 to contain the first mounted structure 100A. Pattern wiring 202 is formed on the bottom surface of the concave section 204 so that the pattern wirings 105 of the first mounted structure 100A are connected to the pattern wiring 202. The pattern wirings 105 and the pattern wiring 202 are electrically connected by connecting layers (bumps) 203 made of, for example, solder.

A side wall surface of the concave section 204 at a position near the opening is formed as, for example, a taper-shaped surface, and a reflection surface 205 is formed on the taper-shaped surface. With this, a light emitted from the semiconductor element (LED) 107 and the optical function layer (fluorescent substance layer) 108 can be efficiently utilized. The reflection surface 205 is formed by sputtering of, for example, a metal, or is formed by polishing the substrate 201.

In addition, in Fig. 2F, after forming the semiconductor device 200, a cap made of, for example, glass can be formed so as to seal the concave section 204.

In Fig. 2F, two semiconductor elements 107 are shown; however, the number of the semiconductor elements 107 is not limited to two, one semiconductor element 107 is allowed and three or more semiconductor elements 107 are also allowed, if necessary.

In the manufacturing method of the semiconductor device according to the present embodiment, the semiconductor element 107 is inspected where the first mounted structure 100 is formed when the semiconductor element 107 is mounted on the substrate 101. However, conventionally, since a semiconductor element (LED) is directly mounted on a substrate similar to the substrate 201 shown in Fig. 2F, when a defective semiconductor element and/or a defective optical function layer is detected, the semiconductor device in which the defective semiconductor element and/or the defective optical function layer is mounted must be discarded.

As described above, in the manufacturing method of the semiconductor device according to the present embodiment, as shown in Fig. 2D, for the first mounted structure 100, that is, at a wafer level, each semiconductor element (LED) 107 is inspected. Further, after the inspection, the first mounted structure 100 is divided into plural first mounted structures 100A, and the semiconductor device 200 is formed by mounting each first mounted structure 100A on the substrate 201.

Therefore, in the present embodiment, a defective semiconductor element 107 and/or a defective optical function layer 108 can be detected before forming the semiconductor device 200. Further, after the inspection, since the first mounted structure 100 is divided into plural first mounted structures 100A, the first mounted structure 100A having the defective semiconductor element 107 and/or the defective optical function layer 108 can be discarded before forming the semiconductor device 200.

Consequently, in the semiconductor device (second mounted structure) 200, the probability of a defective semiconductor element 107 and/or a defective optical function layer 108 being mounted is greatly reduced, and the yield in manufacturing the semiconductor device 200 can be increased. Further, the number of the semiconductor devices 200 which are discarded can be decreased.

In addition, generally, in order to increase the yield of a semiconductor device, there is a method in which each semiconductor element is inspected before being mounted on a substrate. However, in this case, manufacturing of a special testing jig is required and the inspection requires excessive time. Consequently, it is actually difficult to execute the inspection for each element. In addition, when the semiconductor element is an optical function element, it is impossible to execute an actual characteristic inspection without forming an optical function layer, and further it is impossible to form the optical function layer when the semiconductor element is not mounted on a predetermined substrate.

As described above, in the present embodiment, as shown in Fig. 2D, at the wafer level in which plural semiconductor elements 107 are formed, each semiconductor element 107 can be inspected. Therefore, the inspection can be easily executed. Further, the inspection can be executed where the semiconductor element 107 is combined with the optical function layer 108, that is, for example, an LED is combined with a fluorescent substance layer.

Especially, when the substrate 101 is a silicon wafer, existing various inspection instruments can be used as they are. In addition, when the substrate 101 is a silicon wafer, an existing pattern wiring technology and an instrument for forming pattern wirings can be used. For example, the via plugs 103 and the pattern wirings 104 and 105 can be easily formed with a fine structure, and the dicing can be easily executed. Further, since silicon has excellent heat conductivity, heat from the semiconductor element 107 can be easily transferred.

In addition, the structure of the semiconductor device 200 has excellent accuracy for the position and the angle of the semiconductor element 107 when the semiconductor element 107 is disposed on the substrate 201, compared with a conventional semiconductor device. That is, since the semiconductor element 107 mounted on the substrate 101 is mounted on the substrate 201, the disposed position and the disposed angle of the semiconductor element 107 can have excellent accuracy for the substrate 201, compared with a case where a semiconductor element is directly mounted on a substrate of the semiconductor device. Especially, it is generally difficult to mount a fine semiconductor element in a space such as a concave section at high accuracy. However, in the present embodiment, the first mounted structure 100A can be mounted on the substrate 201 of the semiconductor device 200 at high accuracy.

In addition, in the process shown in Fig. 2B, the semiconductor element 107 is connected to the connecting layers 106 (the pattern wirings 104) by ultrasonic bonding instead of using solder. Therefore, contamination of the semiconductor element 107 caused by flux at the soldering is avoided. Especially, when the semiconductor element 107 is an optical function element, input or output light to/from the optical function element is likely to be diffused by the contamination caused by flux and so on. Therefore, it is preferable to use a solder-free method such as the ultrasonic bonding for connecting the semiconductor element 107 to the connecting layers 106.

On the other hand, in the process shown in Fig. 2F, since the pattern wirings 105 are connected to the pattern wiring 202 by the connecting layers 203 which are solder bumps, the pattern wirings 105 can be electrically connected to the pattern wiring 202 excellently. In addition, the first mounted structure 100A can be mounted on the substrate 201 of the semiconductor device 200 at high accuracy due to the self alignment effect of surface tension when the solder is fused.

In addition, the via plugs 103 are formed in the substrate 101 to penetrate the substrate 101, and the pattern wirings 105 connected to the via plugs 103 are connected to the pattern wiring 202 at the second side of the substrate 101 via the connecting layers 203. Therefore, the first mounted structure 100A can be finely formed.

In the above description, the wiring structures and the connecting methods are explained. However, the wiring structures and the connecting methods are not limited to the above description. For example, the following modification and variation are possible.

### [Second Embodiment]

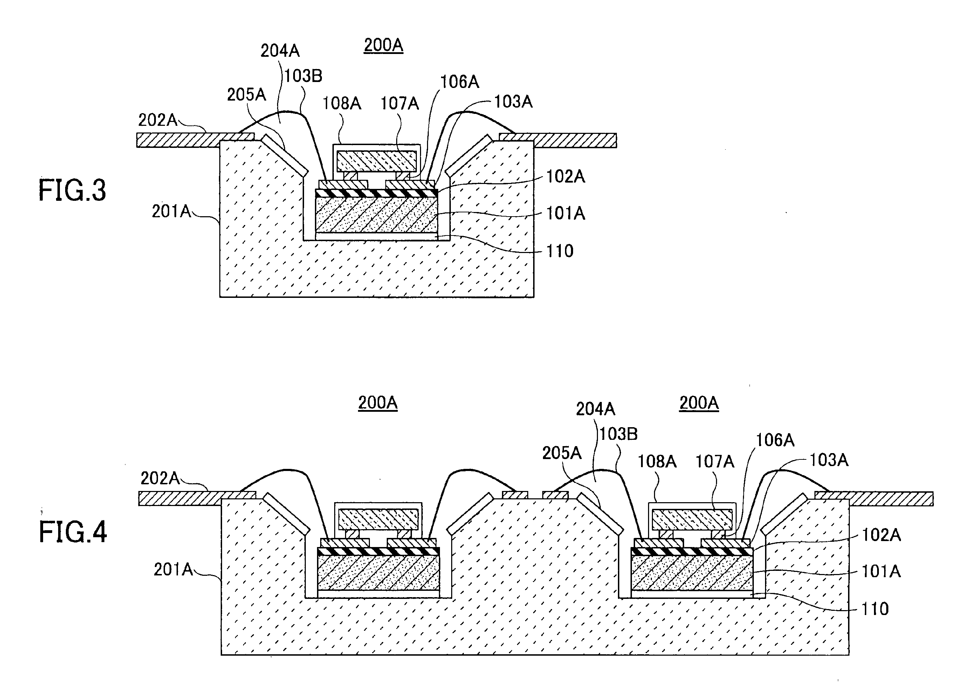

Next, a second embodiment of the present invention is described. In the second embodiment, the first embodiment is modified. Fig. 3 is a schematic cross-sectional view showing a semiconductor device 200A according to the second embodiment of the present invention. As shown in Fig. 3, the semiconductor device 200A includes a substrate 101A made of, for example, silicon on which a semiconductor element 107A is mounted, and a substrate 201A made of, for example, a ceramic material on which the substrate 101A is mounted.

The semiconductor element 107A is similar to the semiconductor element 107 in the first embodiment and has a structure similar to the structure of the semiconductor element 107. Further, an optical function layer 108A similar to the optical function layer 108 in the first embodiment is formed on the semiconductor element 107A.

A concave section 204A which contains the substrate 101A on which the semiconductor element 107A is mounted is formed in the substrate 201A. The concave section 204A is similar to the concave section 204 in the first embodiment.

The substrate 101A is adhered to the substrate 201A by an adhering layer 110 so that the substrate 101A is contained in the concave section 204A. A side wall surface of the concave section 204A at a position near the opening is formed as, for example, a taper-shaped surface, and a reflection surface 205A is formed on the taper-shaped surface. With this, a light emitted from the semiconductor element (LED) 107A and the optical function layer (fluorescent substance layer) 108A can be efficiently utilized. The reflection surface 205A is formed by sputtering of, for example, a metal, or is formed by polishing the substrate 201A.

Pattern wirings 103A made of, for example, Cu are formed on the substrate 101A via an insulation layer 102A, and connecting layers 106A having a structure similar to the connecting layers 106 in the first embodiment are formed on the pattern wirings 103A. The semiconductor element (LED) 107A is connected to the connecting layers 106A by ultrasonic bonding similar to the first embodiment.

Pattern wiring 202A made of, for example, Cu is formed on the substrate 201A, and the pattern wiring 202A is connected to the pattern wirings 103A by wires 103B by wire bonding.

In the semiconductor device 200A according to the second embodiment, the via plugs 103 which penetrate the substrate 101 in the first embodiment are not formed. However, as described above, the pattern wiring 202A on the substrate 201A is connected to the pattern wirings 103A on the substrate 101A by the wires 103B.

Therefore, in the second embodiment, the forming and connection methods of the pattern wirings are easy and the manufacturing processes of the semiconductor device 200A are simplified.

Further, in Fig. 3, after forming the semiconductor device 200A, a cap made of, for example, glass can be formed so as to seal the concave section 204A.

In addition, the number of the substrates 101A having the semiconductor element 107A, which is mounted on the substrate 201A, is not limited to one. For example, as shown in Fig. 4, plural substrates 101A having the semiconductor element 107A can be mounted on the substrate 201A. In this, Fig. 4 is a schematic cross-sectional view showing a modified example of the second embodiment shown in Fig. 3.

Further, in Fig. 4, after forming the semiconductor device 200A, a cap made of, for example, glass can be formed so as to seal the concave section 204A.

A substrate on which a semiconductor element is mounted is not limited to the substrates described in the first and second embodiments, and the following shapes and structures can be applied to the substrate.

### [Third Embodiment]

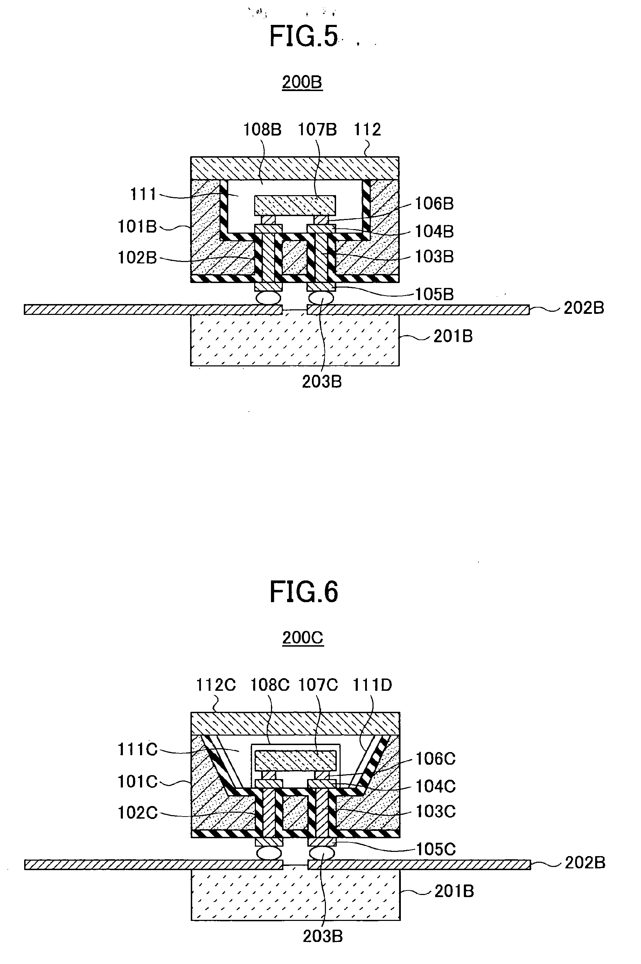

Referring to Fig. 5, a semiconductor device according to a third embodiment of the present invention is described. Fig. 5 is a schematic cross-sectional view showing a semiconductor device 200B according to the third embodiment of the present invention. As shown in Fig. 5, the semiconductor device 200B includes a substrate 101B made of, for example, silicon on which a semiconductor element 107B is mounted, and a substrate 201B made of, for example, a ceramic material on which the substrate 101B is mounted.

The semiconductor element 107B is similar to the semiconductor element 107 in the first embodiment and has a structure similar to the structure of the semiconductor element 107. The semiconductor element 107B is mounted on the substrate 101B so that the semiconductor element 107B is contained in a concave section 111 formed in the substrate 101B. The concave section 111 is formed as an approximate rectangular parallelopiped shape or an approximate cylindrical shape by etching the substrate 101B. After mounting the semiconductor element 107B in the concave section 111, the concave section 111 is filled with an optical function layer 108B. The optical function layer 108B is made of a material similar to the material (fluorescent substance) of the optical function layer 108 in the first embodiment. The concave section 111 can be sealed by a lid section 112 made of, for example, glass.

Via plugs 103B are formed in the substrate 101B so as to penetrate the bottom part of the concave section 111. Pattern wirings 104B are formed on one end of the via plugs 103b and pattern wirings 105B are formed on the other end of the via plugs 103B. An insulation layer 102B is formed between the via plugs 103B and the substrate 101B, on the inner wall surface of the concave section 111, and on the bottom surface of the substrate 101B. The semiconductor element 107B is connected to the pattern wirings 104B via connecting layers 106B by ultrasonic bonding. The pattern wirings 105B are connected to pattern wiring 202B formed on the substrate 201B via connecting layers (bumps) 203B made of solder.

As described above, in the third embodiment, the semiconductor element (LED) 107B is mounted on the substrate 101B so that the semiconductor element 107B is contained in the concave section 111.

### [Fourth Embodiment]

Referring to Fig. 6, a fourth embodiment of the present invention is described. Fig. 6 is a schematic cross-sectional view showing a semiconductor device 200C according to the fourth embodiment of the present invention. In Fig. 6, a substrate 101C, an insulation layer 102C, via plugs 103C, pattern wirings 104C and 105C, connecting layers 106C, a semiconductor element 107C, and a lid 112C are similar to the substrate 101B, the insulation layer 102B, the via plugs 103B, the pattern wirings 104B and 105B, the connecting layers 106B, the semiconductor element 107B, and the lid 112 in the third embodiment. The structure of the semiconductor device 200c is similar to that of the third embodiment. In addition, in Fig. 6, a substrate 201B, pattern wirings 202B, and connecting layers 203B are the same as those in the third embodiment.

However, in the fourth embodiment, a concave section 111C is different from the concave section 111 in the third embodiment and has a taper shape. Further, a reflection surface 111D is formed on the inner surface of the taper-shaped part of the concave section 111C. With this, a light emitted from the semiconductor element (LED) 107C can be efficiently utilized. Further, in the third embodiment, the concave section 111 is fully filled with the optical function layer 108B; however, the concave section 111C is not entirely filled with an optical function layer 108C. That is, the optical function layer 108C is selectively formed to cover the semiconductor element 107C. In this, the concave section 111C can be fully filled with the optical function layer 108C.

According to the embodiments of the present invention, as described above, the semiconductor device can be formed by changing the wiring structures and the shape of the substrates.

As described above, according to the embodiments of the present invention, an individual difference among plural semiconductor elements which are mounted on a substrate can be prevented and the yield in manufacturing a semiconductor device can be increased.

Further, the present invention is not limited to these embodiments, but variations and modifications may be made without departing from the scope of the present invention.

The present invention is based on Japanese Priority Patent Application No. 2005-204794, filed on July 13, 2005, with the Japanese Patent Office, the entire contents of which are hereby incorporated by reference.

## Claims

1. A manufacturing method of a semiconductor device, the manufacturing method **characterized by**:
a first step that mounts a plurality of semiconductor elements (107) on a first substrate (101);
a second step that inspects each of the semiconductor elements (107) mounted on the first substrate (101);
a third step that divides the first substrate (101) by dicing so that a divided first substrate (101) includes at least one semiconductor element (107); and
a fourth step that mounts the divided first substrate (101) in which at least one semiconductor element (107) is mounted on a second substrate (201).

2. The manufacturing method of the semiconductor device as claimed in claim 1, the manufacturing method **characterized in that** the semiconductor element (107) is an optical function element.

3. The manufacturing method of the semiconductor device as claimed in claim 1 or 2, the manufacturing method **characterized in that** the first step includes a step that forms an optical function layer (108) which operates for a transmission light on the semiconductor element (107).

4. The manufacturing method of the semiconductor device as claimed in claim 3, the manufacturing method **characterized in that** the semiconductor element (107) is an LED and the optical function layer (108) is a fluorescent substance layer.

5. The manufacturing method of the semiconductor device as claimed in claim 4, the manufacturing method **characterized in that** the LED is inspected in the second step while emitting light.

6. The manufacturing method of the semiconductor device as claimed in claim 3 or 4, the manufacturing method **characterized in that** the optical function layer (108) is formed by an inkjet method.

7. The manufacturing method of the semiconductor device as claimed in any one of claims 1 through 6, the manufacturing method **characterized in that** wiring sections (104) formed on the first substrate (101) are connected to the semiconductor element (107) via connecting sections (106) by ultrasonic bonding.

8. The manufacturing method of the semiconductor device as claimed in any one of claims 1 through 6, the manufacturing method **characterized in that** wiring sections (105) formed on the first substrate (101) are connected to a wiring section (202) formed on the second substrate (201) by solder.

9. A semiconductor device, the semiconductor device **characterized by**:
a first substrate (101) on which a semiconductor element (107) is mounted; and
a second substrate (201) on which the first substrate (101) is mounted, the semiconductor device **characterized in that** the semiconductor element (107) is an optical function element and an optical function layer (108) which operates for a transmission light is formed on the optical function element.

10. The semiconductor device as claimed in claim 9, the semiconductor device **characterized in that** the optical function element is an LED.

11. The semiconductor device as claimed in claim 9, the semiconductor device **characterized in that** the optical function layer (108) is a fluorescent substance layer.

12. The semiconductor device as claimed in claim 9, the semiconductor device **characterized in that** a concave section (204) is formed in the second substrate (201) so as to contain the first substrate (101) on which the semiconductor element (107) is mounted and a reflection surface (205) is formed on the concave section (204).

13. The semiconductor device as claimed in claim 9, the semiconductor device **characterized in that** wiring sections (103) are formed to penetrate the first substrate (101) and connect the semiconductor element (107) to a wiring section (202) formed on the second substrate (201) via wiring sections (104 and 105) and connecting layers (203).

14. The semiconductor device as claimed in claim 9, the semiconductor device **characterized in that** wiring sections (103A) are formed on the first substrate (101A) to connect to the semiconductor element (107A) via connecting layers (106A), and the wiring sections (103A) are connected to a wiring section (202A) formed on the second substrate (201A) by wire bonding.

15. The semiconductor device as claimed in claim 9, the semiconductor device **characterized in that** a concave section (111) is formed in the first substrate (101B) so as to contain the semiconductor element (107B), and wiring sections (103B) are formed to penetrate the first substrate (101B) so as to connect the semiconductor element (107B) to a second substrate (201B) via connecting sections (104B and 105B) and wiring sections (105B) are connected to a wiring section (202B) formed on the second substrate (201B).

16. The semiconductor device as claimed in claim 9, the semiconductor device **characterized in that** a concave section (111C) is formed in the first substrate (101C) so as to contain the semiconductor element (107C), the concave section (111C) is formed to have a taper shape, a reflection surface (111D) is formed on the taper-shaped surface of the concave section (111C), and wiring sections (103C) are formed to penetrate the first substrate (101C) so as to connect the semiconductor element (107C) to a second substrate (201B) via connecting sections (104C and 105C), and the wiring sections (103C) are connected to a wiring section (202B) formed on the second substrate (201B).

17. The semiconductor device as claimed in any one of claims 9 through 16, the semiconductor device **characterized in that** the first substrate (101, 101A, 101B, or 101C) is a silicon substrate.
